(19) Europäisches Patentamt
European Patent Office
Office européen des brevets

(11) **EP 3 872 143 A1**

(12) **EUROPEAN PATENT APPLICATION**

(43) Date of publication:
**01.09.2021 Bulletin 2021/35**

(21) Application number: **20160050.9**

(22) Date of filing: **28.02.2020**

(51) Int Cl.:
*C09D 11/52* *(2014.01)*       *C09D 11/037* *(2014.01)*
*C09D 11/102* *(2014.01)*       *H05K 1/09* *(2006.01)*
*H01L 31/02* *(2006.01)*       *H01L 31/0224* *(2006.01)*

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Henkel AG & Co. KGaA**
**40589 Düsseldorf (DE)**

(72) Inventors:
• **KOJO, Hiroki**
  **Kanagawa, 1-36-22 (JP)**
• **MATSUNO, Hisashi**
  **Tokyo, 6-12-11 (JP)**

(54) **CONDUCTIVE INK, USE THEREOF, AND METHOD FOR PRODUCING ELECTRONIC CIRCUIT USING THE SAME**

(57)    An object of the present invention is to promote, in a conductive ink comprising silver particles, sintering of the silver particles during curing. The present invention relates to a conductive ink comprising (a) silver particles having a particle size at a cumulative volume of 50% (D50) of 0.1 μm to 10 μm and coated with a surfactant, (b) a liquid thermosetting resin, and (c) a solvent; the liquid thermosetting resin having a viscosity of 2500 (mPa·s) or less.

EP 3 872 143 A1

**Description**

Technical Field

The present invention relates to a conductive ink, use thereof, and a method for producing an electronic circuit using the same.

Background Art

A material that can form a coating film of any shape by any coating method and that allows electricity to flow through the formed coating film is called a conductive ink.

As a known conductive ink, there is a conductive ink comprising silver particles, a thermosetting resin, a hardener, and a solvent (PTL 1). After printing the conductive ink in a circuit shape on a substrate, the thermosetting resin is cured, and the silver is sintered to increase the contact probability of the silver particles, whereby a circuit-shaped conductor can be obtained.

Citation List

Patent Literature

PTL 1: WO2015085534

Summary of Invention

Technical Problem

Silver particles are generally coated with a surfactant for the purpose of, for example, preventing corrosion and agglomeration.

In particular, it is known that compared with bulk-sized silver, nanometer-sized silver particles (silver nanoparticles) have a larger surface area and thus a lower melting point, and can be sintered at lower temperatures. Further, since necking between adjacent particles is likely to occur and the particles are likely to grow, the resulting sintered product has a specific resistance value lower than that of bulk-sized silver.

The present inventors found that in a conductive ink comprising silver particles of submicrometer size or more coated with a surfactant, a liquid thermosetting resin, and a solvent, the viscosity of the liquid thermosetting resin was adjusted to 2,500 mPa·s or less, whereby sintering behavior similar to that of silver nanoparticles was observed, despite the use of silver particles whose particle size was not classified as silver nanoparticles. That is, in this conductive ink, silver can be sintered at a low temperature, and a conductive ink having a lower specific resistance value due to the progress of silver particle growth can be obtained. Such an effect is considered to be obtained because the liquid thermosetting resin heated to the above temperature removes the surfactant on the surface of the silver particles, whereby necking between the silver particles is likely to occur, and sintering is likely to occur.

The present invention has been completed by further study based on this finding, and includes the following aspects.

Item 1. A conductive ink comprising:

(a) silver particles having a particle size at a cumulative volume of 50% (D50) of 0.1 $\mu$m to 10 $\mu$m and coated with a surfactant,
(b) a liquid thermosetting resin, and
(c) a solvent;

the liquid thermosetting resin having a viscosity of 2500 (mPa·s) or less.

Item 2. The conductive ink according to Item 1, wherein the silver particles are spherical particles.

Item 3. The conductive ink according to Item 2, further comprising:

(d) silver flakes having a D50 of 1 $\mu$m to 50 $\mu$m.

Item 4. The conductive ink according to Item 3, wherein the weight ratio ((a):(b)) of the silver particles (a) to the silver flakes (d) is 20:80 to 80:20.

Item 5. The conductive ink according to any one of Items 1 to 4, further comprising:

(e) a binder.

Item 6. The conductive ink according to any one of Items 1 to 5, further comprising:

(f) a hardener.

Item 7. Use of the conductive ink according to any one of Items 1 to 6 as a thermal-curable conductive ink.

Item 8. Use of the conductive ink according to any one of Items 1 to 6 as a conductive ink to be cured at 120°C to 250°C.

Item 9. Use of the conductive ink according to any one of Items 1 to 6 as a conductive ink for use in the production of solar cells.

Item 10. A method for producing an electronic circuit, comprising curing the conductive ink according to any one of Items 1 to 6.

Item 11. The method according to Item 10, comprising curing the conductive ink at 120°C to 250°C.

Item 12. The method according to Item 10 or 11, which is a method for producing a heterojunction solar cell.

Advantageous Effects of Invention

In a conductive ink comprising silver particles of submicrometer size or more, sintering of the silver particles during curing can be promoted.

Description of Embodiments

(a) Silver Particles

The silver particles (a) used in the present invention are silver particles having a particle size at a cumulative volume of 50% (D50) of 0.1 $\mu$m to 10 $\mu$m and coated with a surfactant. The silver particles used in the present invention can be widely selected from those commonly used in conductive inks.

Silver particles are generally coated with a surfactant for the purpose of, for example, preventing corrosion and agglomeration. The surfactant for the silver particles (a) is not limited. Examples includes aliphatic carboxylic acids and the like.

The aliphatic carboxylic acid used as the surfactant for the silver particles (a) preferably has 1 or 2, more preferably 1, carboxy group in the molecule. The aliphatic group contained in the aliphatic carboxylic acid used as the surfactant may be linear, branched, or cyclic, and is preferably linear. The number of carbon atoms in the aliphatic group contained in the aliphatic carboxylic acid used as the surfactant is preferably 3 to 16, and more preferably 3 to 14.

The aliphatic carboxylic acid used as the surfactant for the silver particles (a) may be a saturated aliphatic carboxylic acid or an unsaturated aliphatic carboxylic acid. The number of unsaturated bonds contained in the unsaturated aliphatic group of the unsaturated aliphatic carboxylic acid used as the surfactant is preferably 1 to 3, and more preferably 1 or 2. Specific examples of the aliphatic carboxylic acid used as the surfactant for the silver particles (a) include propionic acid, heptanoic acid, octanoic acid, decanoic acid, lauric acid, tridecanoic acid, mystic acid, pentadecanoic acid, palmitic acid, and the like.

The silver particles (a) have a D50 of 0.1 $\mu$m to 10 $\mu$m. According to the present invention, sintering behaviour similar to that of silver nanoparticles can be obtained, despite the use of silver particles whose particle size is not classified as silver nanoparticles. In this regard, the silver particles (a) may have a D50 of 0.1 $\mu$m to 7 $\mu$m, 0.1 $\mu$m to 5 $\mu$m, 0.1 $\mu$m to 3 $\mu$m, or 0.1 $\mu$m to 2 $\mu$m.

In the present invention, D50 is measured in the following manner. The particle size of silver powder dispersed in a dispersion medium by ultrasonic waves is measured by a laser diffraction method, and the volume-based cumulative distribution is determined by calculation. The particle size at a cumulative point of 50% in the volume-based cumulative distribution is regarded as D50.

The silver particles (a) may be spherical particles or flakes. Further, the silver particles (a) may be a mixture of spherical particles and flakes. The silver particles (a) are preferably spherical particles.

As the silver particles (a), for example, AG-SAB-136 (DOWA Electronics Materials Co., Ltd.), AG-SAB-307 (DOWA Electronics Materials Co., Ltd.), or products similar thereto may be used.

The content ratio of the silver particles (a) to the entire conductive ink is preferably 88 to 94 wt.%, more preferably 90 to 93 wt.%, and even more preferably 91 to 92 wt.%.

(b) Liquid Thermosetting Resin

The conductive ink of the present invention comprises a liquid thermosetting resin (b) having a viscosity of 2500 (mPa·s) or less, whereby when the conductive ink is printed and cured on a surface, a more densified cured product can be obtained. In this case, since the contact probability of the silver particles is improved, a cured product having a lower resistivity can be obtained. Further, during heat-curing, the heated liquid thermosetting resin removes the surfactant on the surface of the silver particles, whereby necking between the silver particles is likely to occur, and sintering is likely to occur.

In the present invention, the viscosity of the liquid thermosetting resin (b) is measured according to the capillary viscometer method of JIS 7233.

The liquid thermosetting resin (b) can be widely selected from those commonly used in conductive inks, as long as the viscosity is 2500 (mPa·s) or less.

The liquid thermosetting resin (b) is preferably one having a viscosity of 250 (mPa·s) or more, because the resulting conductive ink has excellent adhesion.

The viscosity of the liquid thermosetting resin (b) is preferably 250 to 2500 (mPa·s), more preferably 300 to 2300 (mPa·s), and even more preferably 300 to 1500 (mPa·s).

Examples of the liquid thermosetting resin (b) include epoxy resins, phenol resins, alkyd resins, polyurethane resins, silicone resins, and the like.

As the liquid thermosetting resin (b), which is an epoxy resin, various types of epoxy resins, such as bisphenol A type, bisphenol F type, monofunctional, bifunctional, multifunctional, and dicyclopentadienyl methacrylate (DCPDM) type epoxy resins, can be used. A diluent may be added, if necessary. In particular, bisphenol A type, bisphenol F type, and multifunctional epoxy resins, etc., are preferable, because sintering of the silver particles is further promoted, and a conductive ink having good adhesion can be obtained.

Examples of the liquid thermosetting resin (b), which is an epoxy resin, include multifunctional X-321L (Nagase ChemteX Corporation), bisphenol F type EXA-830-CRP (DIC Corporation), YDF-870GS (Nippon Steel Chemical & Material Co., Ltd.), and the like.

The thermosetting resins (b) may be used singly or in combination or two or more.

The total content ratio of the thermosetting resin(s) (b) to the entire conductive ink is preferably 0.9 to 3.7 wt.%, more preferably 1.1 to 2.7 wt.%, and even more preferably 1.4 to 2.1 wt.%.

(c) Solvent

The conductive ink of the present invention comprises a solvent (c) for the purpose of dispersing the liquid thermosetting resin and imparting an appropriate viscosity.

The solvent (c) is not limited and can be selected from a wide range. Usable examples include ester-based solvents, alcohol-based solvents, glycol ether-based solvents, glycol ester-based solvents, hydrocarbon-based solvents, ether-based solvents, and the like.

Specific examples of glycol ether-based solvents include methyl carbitol, ethyl carbitol, butyl carbitol, Methotate (propylene glycol monomethyl ether propionate; Sankyo Chemical Co., Ltd.), and the like.

Specific examples of glycol ester-based solvents include ethyl cellosolve acetate, PMA, butyl carbitol acetate, ethyl carbitol acetate, and the like.

The solvents (c) may be used singly or in combination or two or more.

The total content ratio of the solvent(s) (c) to the entire conductive ink is preferably 2 to 10 wt.%, more preferably 3 to 8 wt.%, and even more preferably 4 to 7 wt.%.

(d) Silver Flakes

When the silver particles (a) are spherical particles, the conductive ink of the present invention may further comprise silver flakes (scales) having a D50 of 1 $\mu$m to 50 $\mu$m. Spherical particles come into point contact with each other, whereas flakes come into surface contact with each other; thus, a mixture of spherical particles and flakes has improved conductivity, compared with spherical particles alone.

The D50 of the silver flakes (d) is preferably 2 $\mu$m to 30 $\mu$m, more preferably 3 $\mu$m to 15 $\mu$m, and even more preferably 4 $\mu$m to 10 $\mu$m.

The weight ratio ((a):(d)) of the silver particles (a), which are spherical particles, and the silver flakes (d) is not limited, and may be, for example, 20:80 to 80:20, preferably 30:70 to 70:30, and more preferably 40:60 to 60:40.

The mixture of the silver particles (a), which are spherical particles, and the silver flakes (d) may be, for example, FA-SAB-499 (DOWA Electronics Materials Co., Ltd.) or a product similar thereto.

(e) Binder

The conductive ink of the present invention preferably further comprises a binder for the purpose of fixing the liquid thermosetting resin during curing to create a three-dimensional chain structure, improving the adhesion to the surface to be coated, and controlling the characteristics and durability of the cured coating film.

The binder (e) is not limited and can be selected from a wide range. Further, it can be suitably selected in consideration of compatibility with the surface to be coated. For example, when the surface to be coated is rigid, like a printed circuit board, a phenol-based or epoxy-based resin is preferable. When the surface to be coated is rich in flexibility, like a film, a cellulose ester-based, polyester-based, or rubber-based resin is preferable.

Specific examples of phenol-based binders include a liquid resol resin PR-23 (Sumitomo Bakelite) and the like.

Specific examples of epoxy-based binders include EXA-830-CPR (DIC Corporation) and the like.

Specific examples of cellulose ester-based binders include CAB 381-2 (Tomoe Engineering Co., Ltd.) and the like.

Specific examples of polyester-based binders include Vitel® 2700B (Bostik) and the like.

Specific examples of silicone-based binders include Andisil® VQM 1 (AB Specialty Silicones), PLY2-7530 (NuSil), and the like.

The binders (e) may be used singly or in combination of two or more.

The total content ratio of the binder(s) (e) to the entire conductive ink is preferably 0.1 to 30 wt.%, more preferably 0.5 to 10 wt.%, and even more preferably 1 to 5 wt.%.

(f) Hardener

The conductive ink of the present invention optionally comprises a hardener for the purpose of curing the liquid thermosetting resin.

The hardener (f) is not limited, and can be widely selected from hardeners for thermosetting resins. Usable examples include imidazole-type hardeners, amine-type hardeners, acid anhydride-type hardeners, latent hardeners, and the like.

Specific examples of imidazole-type hardeners include Curezol® 2E4MZ, 1B2MZ, and 1B2PZ (Shikoku Chemicals Corporation), and the like.

Specific examples of amine-type hardeners include AJICURE® PN-23J (Ajinomoto) and the like.

The hardeners (f) may be used singly or in combination of two or more.

The total content ratio of the hardener(s) (f) to the liquid thermosetting resin (b) is preferably 0.51 to 50 wt.%, more preferably 1 to 30 wt.%, and even more preferably 2 to 8 wt.%.

In the conductive ink of the present invention, when the amount of the liquid thermosetting resin and the hardener is 100 parts by weight, the weight ratio of the hardener is preferably 2 to 15 parts by weight, more preferably 2 to 10 parts by weight, and even more preferably 4 to 8 parts by weight.

(g) Other Components

The conductive ink of the present invention may further contain other components. Examples of other components include Dispalone (Mitsubishi Rayon Co., Ltd.), fumed silica, and the like as thixotropic agents (viscosity- and viscosity ratio-adjusting agents).

Use

The conductive ink of the present invention can be used as a thermal-curable conductive ink. Specifically, it can be used as a conductive ink to be cured at 120°C to 250°C. The conductive ink of the present invention can be preferably used as a conductive ink to be cured at 120°C to 200°C. The conductive ink of the present invention can be cured in the above temperature range. Since the performance of heterojunction solar cells generally deteriorates when they are exposed to a high temperature of 200°C or higher, it is preferable to perform treatment in a temperature range of 200°C or lower in the production thereof. Therefore, the conductive ink of the present invention can be preferably used for the production of heterojunction solar cells.

Examples

Components were mixed with the following compositions to thereby prepare conductive inks of Examples 1 to 9 and Comparative Examples 1 to 8.

   Silver particles: 93.60 g
   Liquid epoxy resin: 1.88 g
   Hardener: 0.16 g
   Solvent: 3 to 4 wt.% (each adjusted to the optimum printing viscosity depending on the type of silver particles)
   Binder: 0.1 g

The silver particles shown in Table 1 were used. FA-SAB-499 (DOWA Electronics Materials Co., Ltd.) is a mixture of silver spherical particles having a D50 of 1.2 μm and silver flakes having a D50 of 9 to 11 μm (silver spherical particles : silver flakes = 50:50 (weight ratio)). These silver particles are coated with a surfactant.

AG-SAB-136 (DOWA Holdings Co., Ltd.) is silver spherical particles having a D50 of 1.0 μm. These silver particles are coated with a surfactant.

AG-SAB-307 (DOWA Holdings Co., Ltd.) is silver spherical particles having a D50 of 1.2 μm. These silver particles are coated with a surfactant.

In Example 11, silver spherical particles having a D50 of 0.3 μm were used. These silver particles are coated with a surfactant.

The liquid epoxy resins shown in Table 1 were used.

The hardener used was Curezol® (Shikoku Chemicals Corporation).

The solvents shown in Table 1 were used. "BC" represents butyl carbitol, and "BCA" represents butyl carbitol acetate.

The binder used was CAB 381-2 (Tomoe Engineering Co., Ltd.). When the solvent (d) was BC, the binder dispersed in BC (5 wt.%) was used. When the solvent (d) was BCA, the binder dispersed in BCA (10 wt.%) was used.

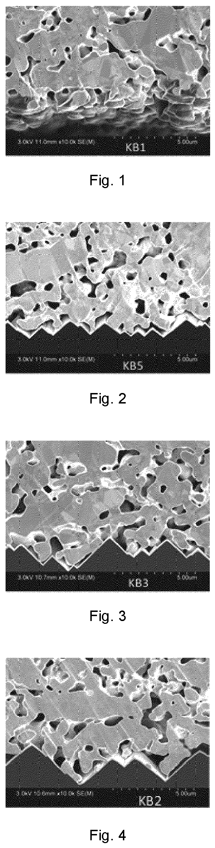

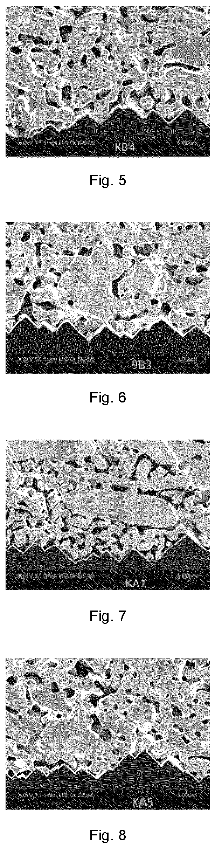

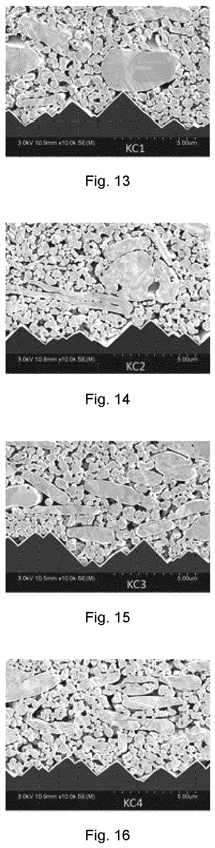

Each conductive ink was evaluated as follows. Table 1 and Figs. 1 to 16 show the evaluation results.

Curing Conditions

After each conductive ink was printed, the solvent was evaporated by heating in an open oven at 150°C for 20 minutes, followed by further heating at 180°C for 60 minutes.

Photographing of Cross-Sectional Views

Ion milling for finger cross-section was performed using the following equipment under the following conditions.

Equipment: Ion Milling System (Manufacturer: Hitachi High-Tech; Model: IM4000 Plus)
Optimized conditions:

Acceleration voltage: 6 V
Discharge voltage: 1.5 kV
Ar gas flow: 0.10 cm3/min
Milling time: 2 hr
Stage control: C3 (±30 deg, 3 reciprocations/min)
Stage rotation: 90 deg
Eccentric value: 0 deg

Photographs were taken with high magnification by SEM using the following equipment under the following conditions.

Equipment: FE-SEM (Manufacturer: Hitachi High-Tech; Model: S-4800)
Resolution of secondary electron: 1.0 nm at 15 kV; 2.0 nm at 1 kV
Acceleration voltage: 0.5-30 kV
Magnification: x30-x800,000
Optimized conditions:

Acceleration voltage: 3 kV
Working distance: 8-12 mm
Magnification: x2000, x10,000, x20,000, and x50,000

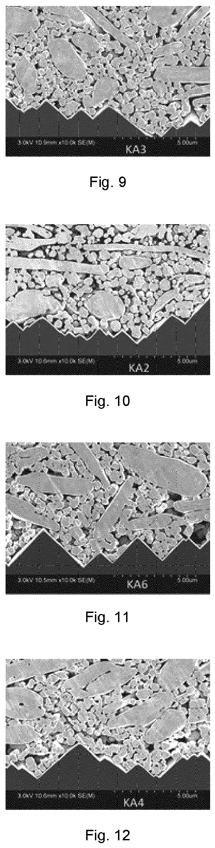

Figs. 1 to 8 show cross-sectional views of the conductive inks of Examples 1 to 5, 7, 8, and 10 after curing, and Figs. 9 to 16 show cross-sectional views of the conductive inks of Comparative Examples 1 to 8 after curing.

Measurement of Resistivity

According to the following formula, the resistance value and cross-sectional area were measured as follows, and the specific resistance value was determined by calculation.

$$\rho = RS/L$$

$\rho$: Specific resistance value ($\mu$ohm·cm)
R: Resistance value (ohm)
S: Cross-sectional area of wiring (cm2)
L: Length of wiring (cm) (determined by the distance between the probes of the resistance measurement device)

Each measurement was performed as follows.
Cross-sectional area of wiring: The cross-sectional areas of wiring at several locations were measured using a VK-9700 (produced by Keyence Corporation) at a magnification of x100, and the average value was determined.
Resistance value: The wire resistance value was measured by GOM-804 Milliohm Meter (produced by Texio Technology Corporation) in the range of 5$\Omega$.
The conductive inks of Examples 1 to 10 differ from those of Comparative Examples 1 to 8 in that the viscosity of the liquid epoxy resin is 2500 (mPa·s) or less. In the conductive inks of Examples 1 to 10, sintering of the silver particles during curing was further promoted (Figs. 1 and 3), and the resistivity was lowered (Table 1).
In contrast, in the conductive inks of Comparative Examples 1 to 8, in which the viscosity of the liquid epoxy resin exceeded 2500 (mPa·s), sintering of the silver proceeded to a lesser extent during curing than in the Examples (Figs. 2 and 4), and the resistivity was thus increased (Table 1).

Table 1

| | Ag powder | | Solvent | Epoxy resin | | | | Results | | |
|---|---|---|---|---|---|---|---|---|---|---|
| | Product | Shape | | Product | Manufactu rer | Type | State | Viscosity (mPa·s) | Necking | Resistivity (μohm·cm) |
| Example 1 | FA-SAB-499 | Mixture of spherical powder and flake powder | BC | JER YED188 | Mitsubishi Chemical | Reactive diluent | Liquid | 5 | Excellent | 3.8 |
| Example 2 | FA-SAB-499 | Mixture of spherical powder and flake powder | BC | EX-810P | Nagase ChemteX | Bifunctional | Liquid | 10 | Excellent | 3.9 |
| Example 3 | FA-SAB-499 | Mixture of spherical powder and flake powder | BC | EP-3980S | Adeka | DCPDM | Liquid | 30 | Excellent | 3.8 |
| Example 4 | FA-SAB-499 | Mixture of spherical powder and flake powder | BC | EP-4088L | Adeka | DCPDM | Liquid | 230 | Excellent | 4.4 |
| Example 5 | FA-SAB-499 | Mixture of spherical powder and flake powder | BC | EX-321L | Nagase ChemteX | Multifunctio nal | Liquid | 300 | Excellent | 4.0 |
| Example 6 | AG-SAB-307 | Spherical powder alone | BCA | EX-321L | Nagase ChemteX | Multifunctio nal | Liquid | 301 | Excellent | 5.0 |
| Example 7 | FA-SAB-499 | Mixture of spherical powder and flake powder | BCA | EXA-830-CRP | DIC | Bisphenol F | Liquid | 1300 | Excellent | 3.7 |
| Example 8 | FA-SAB-499 | Mixture of spherical powder and flake powder | BC | EXA-830-CRP | DIC | Bisphenol F | Liquid | 1300 | Excellent | 3.6 |
| Example 9 | 1015685 | Spherical powder alone | BC | EXA-831-CRP | DIC | Bisphenol F | Liquid | 1300 | Excellent | 3.3 |
| Example 10 | FA-SAB-499 | Mixture of spherical powder and flake powder | BC | YDF-870GS | Nippon Steel Chemical & Material | Bisphenol F | Liquid | 2300 | Good | 3.7 |
| Com. Ex 1 | FA-SAB-499 | Mixture of spherical powder and flake powder | BC | JER 806H | Mitsubishi Chemical | Bisphenol F | Liquid | 3000 | Defective | 6.9 |
| Com. Ex 2 | FA-SAB-499 | Mixture of spherical powder and flake powder | BC | EXA-850-CRP | DIC | Bisphenol A | Liquid | 4500 | Defective | 6.4 |
| Com. Ex 3 | FA-SAB-499 | Mixture of spherical powder and flake powder | BC | YD-825GS | Nippon Steel Chemical & Material | Bisphenol A | Liquid | 8250 | Defective | 6.4 |

(continued)

| | Ag powder | | Solvent | Epoxy resin | | | | Results | | |
|---|---|---|---|---|---|---|---|---|---|---|
| | Product | Shape | | Product | Manufactu rer | Type | State | Viscosity (mPa·s) | Necking | Resistivity (μo hm·cm ) |
| Com. Ex 4 | FA-SAB-499 | Mixture of spherical powder and flake powder | BC | JER 827 | Mitsubishi Chemical | Bisphenol A | Liquid | 100000 | Defective | 6.6 |
| Com. Ex 5 | FA-SAB-499 | Mixture of spherical powder and flake powder | BC | JER 1001 | Mitsubishi Chemical | Bisphenol A | Solid | 100000000 | Defective | 7.6 |
| Com. Ex 6 | FA-SAB-499 | Mixture of spherical powder and flake powder | BC | JER 4005P | Mitsubishi Chemical | Bisphenol F | Solid | 100000000 | Defective | 6.6 |
| Com. Ex 7 | FA-SAB-499 | Mixture of spherical powder and flake powder | BC | YD-011 | Nippon Steel Chemical & Material | Bisphenol A | Solid | 100000000 | Defective | 7.8 |
| Com. Ex 8 | FA-SAB-499 | Mixture of spherical powder and flake powder | BC | YDF-2001 | Nippon Steel Chemical & Material | Bisphenol F | Solid | 100000000 | Defective | 7.5 |

**Claims**

1.  A conductive ink comprising:

    (a) silver particles having a particle size at a cumulative volume of 50% (D50) of 0.1 $\mu$m to 10 $\mu$m and coated with a surfactant,
    (b) a liquid thermosetting resin, and
    (c) a solvent;

    the liquid thermosetting resin having a viscosity of 2500 (mPa·s) or less.

2.  The conductive ink according to claim 1, wherein the silver particles are spherical particles.

3.  The conductive ink according to claim 2, further comprising:
    (d) silver flakes having a D50 of 1 $\mu$m to 50 $\mu$m.

4.  The conductive ink according to claim 3, wherein the weight ratio ((a):(b)) of the silver particles (a) to the silver flakes (d) is 20:80 to 80:20.

5.  The conductive ink according to any one of claims 1 to 4, further comprising:
    (e) a binder.

6.  The conductive ink according to any one of claims 1 to 5, further comprising:
    (f) a hardener.

7.  Use of the conductive ink according to any one of claims 1 to 6 as a thermal-curable conductive ink.

8.  Use of the conductive ink according to any one of claims 1 to 6 as a conductive ink to be cured at 120°C to 250°C.

9.  Use of the conductive ink according to any one of claims 1 to 6 as a conductive ink for use in the production of solar cells.

10. A method for producing an electronic circuit, comprising curing the conductive ink according to any one of claims 1 to 6.

11. The method according to claim 10, comprising curing the conductive ink at 120 °C to 250°C.

12. The method according to claim 10 or 11, which is a method for producing a heterojunction solar cell.

Fig. 1

Fig. 2

Fig. 3

Fig. 4

Fig. 5

Fig. 6

Fig. 7

Fig. 8

Fig. 9

Fig. 10

Fig. 11

Fig. 12

Fig. 13

Fig. 14

Fig. 15

Fig. 16

Europäisches
Patentamt

European
Patent Office

Office européen
des brevets

# EUROPEAN SEARCH REPORT

Application Number

EP 20 16 0050

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 2010 083953 A (MITSUBISHI MATERIALS CORP) 15 April 2010 (2010-04-15) * claims; examples 1-6; table 1 * * paragraph [0033] * ----- | 1-12 | INV. C09D11/52 C09D11/037 C09D11/102 H05K1/09 H01L31/02 |
| A,D | WO 2015/085534 A1 (ABLESTIK SHANGHAI LTD [CN]; HENKEL AG & CO KGAA [DE]) 18 June 2015 (2015-06-18) * claims; figures; examples * ----- | 1-12 | ADD. H01L31/0224 |

TECHNICAL FIELDS
SEARCHED     (IPC)

C09D
C08K
H05K
H01L

The present search report has been drawn up for all claims

| Place of search | Date of completion of the search | Examiner |
|---|---|---|
| Munich | 31 August 2020 | Hollender, C |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 20 16 0050

This annex lists the patent family members relating to the patent documents cited in the above-mentioned European search report.
The members are as contained in the European Patent Office EDP file on
The European Patent Office is in no way liable for these particulars which are merely given for the purpose of information.

31-08-2020

| Patent document cited in search report | Publication date | Patent family member(s) | Publication date |
|---|---|---|---|
| JP 2010083953 A | 15-04-2010 | JP 5277844 B2<br>JP 2010083953 A | 28-08-2013<br>15-04-2010 |
| WO 2015085534 A1 | 18-06-2015 | NONE | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2015085534 A